# EUROPEAN PATENT APPLICATION

(11) **EP 4 626 172 A1**
(43) Date of publication of application: **01.10.2025**
(21) Application number: 25150615.0
(22) Date of filing: 08.01.2025
(51) Int. Cl.: H10D 84/01, H10D 30/00, H10D 64/27, H10D 88/00

(54) **RIBBON COMPLEMENTARY FET (CFET) METAL GATE MULTI-VOLTAGE THRESHOLD INTEGRATION**

(30) Priority: 29.03.2024 US 202418621549
(71) Applicant: Intel Corporation, Santa Clara, CA 95054 (US)
(72) Inventor: XU, Guowei, Portland, 97229 (US); ZHANG, Yang, Rio Rancho, 87124 (US); CHU, Tao, Portland, 97229 (US); CHAO, Robin, Portland, 97209 (US); ZHANG, Kan, Hillsboro, 97123 (US); HUANG, Chiao-Ti, 244 New Taipei (TW); HUNG, Ting-Hsiang, Beaverton, 97007 (US); ZHANG, Feng, Portland, 97229 (US); LIN, Chia-Ching, Portland, 97229 (US); YEUNG, Chun Wing, Portland, 97229 (US); LIN, Chung-Hsun, Portland, 97229 (US); MURTHY, Anand, Portland, 97229 (US); GOLONZKA, Oleg, Beaverton, 97007 (US)
(74) Representative: Goddar, Heinz J.

(57) **Abstract**

A stacked complementary field-effect device (CFET) device includes a bottom contact region and a top contact region. A plurality of stacked CFET devices is between the bottom contact region and the top contact region. Respective ones of the plurality of stacked CFET devices comprise a first transistor layer of a first type over the bottom contact region, and a second transistor layer of a second type over the first transistor layer. The first transistor layer comprises a first plurality of channels surrounded by a first metal gate stack, and the second transistor layer comprises a second plurality of channels surrounded by a second metal gate stack, wherein the respective ones of the plurality of stacked CFET devices include different combinations of N dipole doses and a P dipole dose in both the first metal gate stack and the second metal gate stack.

## Description

### BACKGROUND

The demand for logic devices and memory devices has increased. This demand is further amplified due to the integration of accelerators such as Tile Matrix Multiply (TMUL) units, Advanced Vector Extensions (AVX) and Vision Processing Units (VPU) to support new workloads. RibbonFETs, or gate-all-around (GAA) FETs, are a new transistor architecture that is a default candidate for supporting these workloads and enabling n-chip higher density by stacking n- and pMOS devices atop each other. However, the choice of a threshold voltage in complementary field effect transistors (CFETs), such as RibbonFETs, involves carefully balancing the performance requirements with the power constraints of the target application.

### BRIEF DESCRIPTION OF THE DRAWINGS

FIG. 1A depicts a perspective view of a complementary field-effect transistor (CFET) transistor.
FIG. 1B depicts an example layout view of a front side (FS) of an array of CFET cells.
FIG. 1C depicts an example cross-sectional parallel-to-gate side view of a stacked CFET device in a CFET cell FIG. 1A along cross-section line A in FIG. 1B.
FIG. 2 depicts an example cross-sectional parallel-to-gate side view of a stacked CFET structure 240 along the cross-section line B in FIG. 1B.
FIG. 3 is diagram illustrating a process for fabricating a CFET structure comprising a plurality of adjacent stacked CFET devices using volumeless NMOS dipole (nD) and PMOS dipole (pD).
FIGS. 4A-4NN are diagrams illustrating parallel-to-gate (PGD) views of sub processes of the processes described in FIG. 3.
FIG. 5 illustrates an example of components that may be present in a computing system for implementing the techniques (e.g., operations, processes, methods, and methodologies) described herein.

### DESCRIPTION OF THE EMBODIMENTS

Methods and architectures for partially recessing deep via backside (DVB) for capacitance reduction in complementary FET (CFET) transistors are described. In the following detailed description, reference is made to the accompanying drawings that form a part hereof wherein like numerals designate like parts throughout, and in which is shown by way of illustration embodiments that may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/-10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

As technology scales down and transistor dimensions continue to shrink, threshold voltage levels and their impact on performance and power consumption may vary, requiring careful optimization and design considerations.

One or more embodiments described herein are directed to structures and architectures for fabricating stacked CFET devices and CFET arrays in which multiple threshold voltages (Vt) are integrated into respective stacked CFET devices of the same CFET design, with different Vt types for different stacked CFET devices using volumeless nD and pD for Vt separation. Embodiments may include or pertain to one or more of CFETs with backside power, SRAMs, and system-on-chip (SoC) technologies. One or more embodiments may be implemented to realize high-performance CFETs and SoCs of future technology nodes. These and other features will be further apparent in view of the following discussion.

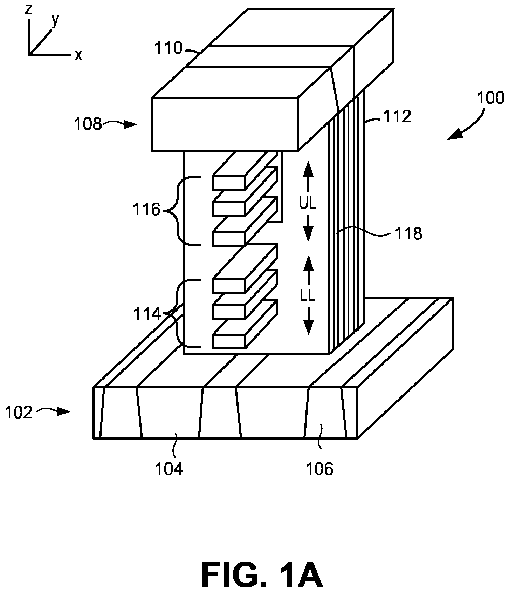

For context, FIG. 1A depicts a perspective view of a complementary field-effect transistor (CFET) device 100. The CFET is a product of an evolution of transistor technology from Fin Field-Effect Transistor (FinFET) to nanosheet FET to CFET. CFET enables a 50% front end scaling with n-type metal-oxide-semiconductor (nMOS) transistors stacked vertically on top of p-type metal-oxide-semiconductor (pMOS) transistors. CFET technology vertically stacks nNMOS and pMOS nanosheet or nanoribbon MOSFETs with a shared gate.

The bottom of the CFET device 100 includes a bottom contact region 102 comprising a substrate region with one or more metal lines 106 (part of a bottom metal layer). The substrate region 104 extends in an x-y plane. The top of CFET device 100 includes a top contact region 108 with a metal line 110 (part of a top metal layer). The bottom contact region 102 beneath the CFET device 100 is used to connect voltages/signals to the transistors.

An elevated region 112 includes a lower layer (LL), e.g., a first transistor layer 114 (an n-type transistor layer) with one or more nMOS transistors (nMOSFETs). An upper layer (UL), e.g., a second transistor layer 116 (n p-type transistor layer) with one or more pMOS transistors (pMOSFETs) over the lower layer (LL). The second transistor layer 116 may overlay, at least in part, and have an overlapping footprint with, the first transistor layer 114. In this example, each transistor includes three channels in the form of ribbons, where each channel is surrounded by a gate structure 118, as a gate-all-around transistor. The transistors can also be referred to as RibbonFETs. Three channels is an example, as 2-5 channels can be used, for example. nMOS source and drain regions (not shown) can be connected to pMOS source and drain regions (not shown) through vias since they are on different layers, e.g., the pMOS layer on the top and the nMOS layer on the bottom. In one embodiment, nMOS source and drain regions can be located on the backside of CFET device 100.

Dense CFET logic or memory cells using complementary transistors can be used in a variety of applications such as a system-on-a-chip (SoC) where density, performance and power consumption are bottlenecks. Other example applications include those with multiple integrated circuits within the same package, e.g., stacked tile/chiplet designs and other system-in-a-package designs that include multiple chips.

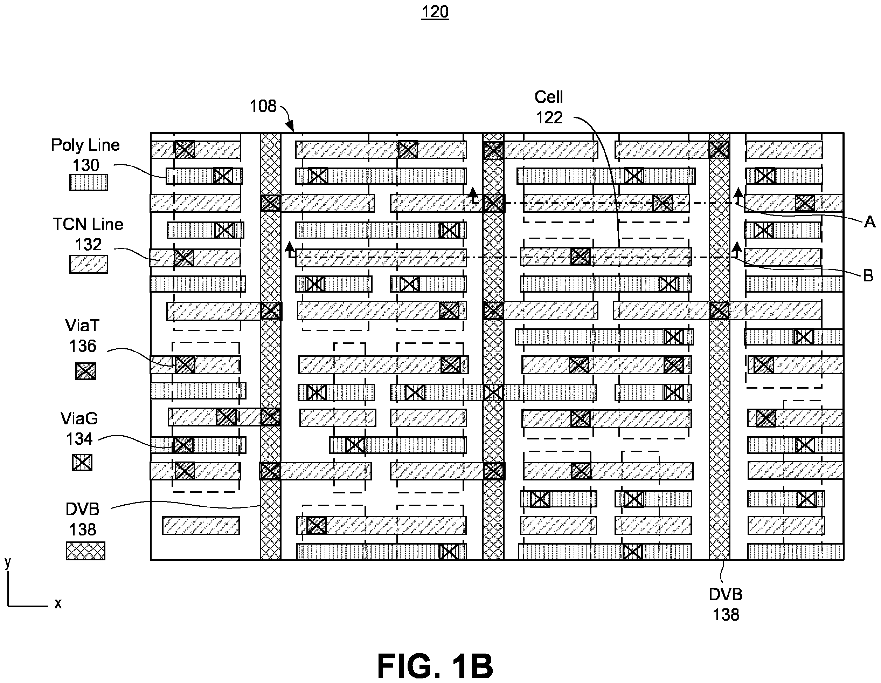

FIG. 1B depicts an example layout view of a front side (FS) of an array of CFET cells. The view is in the x-y plane looking from a top or front side of the cell (a side of the cell facing away from the substrate on which the cell if formed). In particular, the view depicts the metal lines in the top contact region 108 (FIG. 1A) or top metal layer. A region with an X generally denotes a via extending in the z direction, either toward or away from the substrate. The metal lines 110 may comprise various nodes, word lines and other conductive paths on the pMOS and nMOS layers may include a conductive material such as doped polysilicon. In some cases, the doped polysilicon contacts a source/drain region of a transistor as a trench contact (TCN).

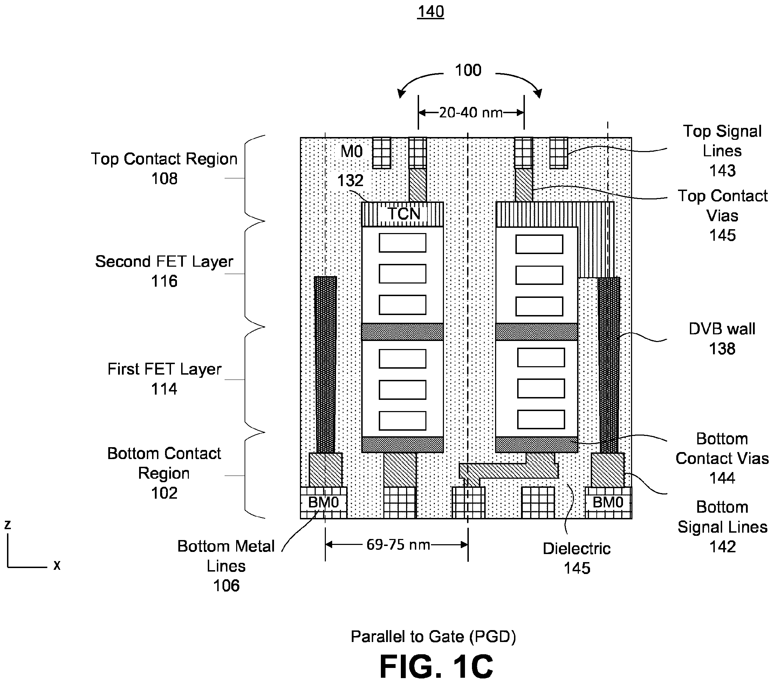

As depicted, the CFET array 120 comprises a plurality of CFET cells 122, denoted with a dashed outline. Each CFET cell 122 is located in a particular column of the CFET array 120 and comprises a plurality of CFET devices 140 (FIG. 1C), which are beneath the metal lines 110 of top contact region 108. Upper and lower-level transistor layers and the bottom or back side of the cell (a side of the cell facing the substrate) are not viewable. The CFET transistors of each CFET cell 122 occupy adjacent rows of the CFET array 120 in the y-direction. The CFET devices 100 may be located in an n-type diffusion region or a p-type diffusion region.

The metal lines 110 comprising the top contact region 108 may include polysilicon (poly) lines 130 and trench contact (TCN) lines 132. The metal lines 110 may also include vias, which include gate contact vias (ViaG or VCG) 134 over poly lines 130 and TCN vias (ViaT or VCT) 136 over TCN lines 132.

The top contact region 108 further includes one or more deep via backside (DVB) walls 138 (also referred to as a backside wall or a via contact). The DVB walls 138 connect TCN lines 132 to a source or drain region in the backside or bottom contact region 102 through ViaT 136. As shown, DVB walls 138 may span a length of the CFET array 120 in the y-direction and run adjacent to columns of the CFET cells 122. Along any given row of the CFET array 120, the DVB wall 138 may be adjacent to either a TCN line 132 or a poly line 130. In one embodiment, there is at least one column of CFET cells 122 between a pair of DVB walls 138.

FIG. 1C depicts an example cross-sectional parallel-to-gate side view of a stacked CFET structure 140 along cross-section line A in FIG. 1B, where like components from FIG. 1B have like reference numerals. Cross-section line A represents a parallel to gate (PGD) over a TCN view. CFET structure 140 is shown comprising two adjacent stacked CFET devices 100 between bottom contact region 102 and top contact region 108.

Bottom contact region 102 comprises bottom metal lines 106 (or backside metal lines) extending in a first direction (e.g., y-direction) in one or more bottom (backside) metal layers, e.g., BM0, BM1. Bottom contact region 102 further includes bottom signal lines 142, and bottom contact vias 144. The top contact region 108 comprises metal lines (top or front side metal lines) extending in a second direction (e.g., x-direction) orthogonal (+/- 5 degrees) to the first direction. The top metal lines 143 are in one or more front side (top) metal layers, e.g., M0, M1. The top contact region 108 further includes top contact vias 145 (e.g., ViaT 136 and ViaG 134).

The stacked CFET devices 100 include a first FET layer 114 of a first type over the bottom contact region 102, and a second FET layer 116 of a second type over the first FET layer 114. The top contact region 108 is over the second FET layer 116. In one embodiment, the first type is an N-type FET and the second type is a P-type FET. In another embodiment, the first type is a P-type FET and the second type is an N-type FET.

The first FET layer 114 and the second FET layer 116 comprise a patterned workfunction (PWF), which refers to the formation of gate electrodes with different work functions for the n-channel and p-channel devices to optimize threshold voltages and performance of each transistor type. The n-type FET comprises an nWF metal layer stack and the p-type FET layer comprises a pWF metal layer stack, where the nWF metal layer stack and the pWF metal layer stack are in vertical alignment.

In this view, TCN line 132 is shown over the stacked CFET devices 100 in the top contact region 108. DVB walls 138 are along the first direction (the y-direction) parallel with bottom metal lines 106 in bottom contact region 102. Each DVB wall 138 is adjacent to a respective stacked CFET device 100. The DVB walls 138 extend in the z-direction between the top contact region 108 adjacent to the first FET layer 114, the second FET layer 116, and the bottom contact region 102. In this example, the DVB wall terminates on bottom signal line 142 in the bottom contact region 102. DVB walls 138 are filled with metal. A dielectric 145 such as SiO₂ covers components of the stacked CFET devices 100.

In embodiments, the centerline of the top via contacts 145 of adjacent stacked CFET devices 100 may be separated by a distance of approximately 20 - 40 nm, and more specifically, by a distance of approximately 27-33 nm. In embodiments, the distance between a centerline of DVB wall 138 and an opposite boundary of an adjacent stacked CFET device 100 may range from approximately 65 - 85 nm, and more specifically a distance of about 69-75 nm.

In accordance with one or more embodiments described herein, a CFET structure of adjacent stacked ribbon CFET devices integrates multiple voltage threshold types using volumeless N dipole and P dipole at channel interfaces. The CFET structure comprises four adjacent stacked CFET devices between a bottom contact region and a top contact region. Respective stacked CFET devices include and n-type ribbon channels (with an nWF layer) and p-type ribbon channels (with a pWF metal layer), the n-type ribbon channels and p-type ribbon channels being in vertical alignment. Each of the stacked CFET devices has different voltage threshold (Vt) types based on different combinations of N dipole doses in the n-type ribbon channels and P dipole doses in the p-type ribbon channels. The different voltage threshold types comprise a high voltage threshold (HVT), a standard voltage threshold (SVT), a low voltage threshold (LVT), and an ultra-low voltage special (ULVT).

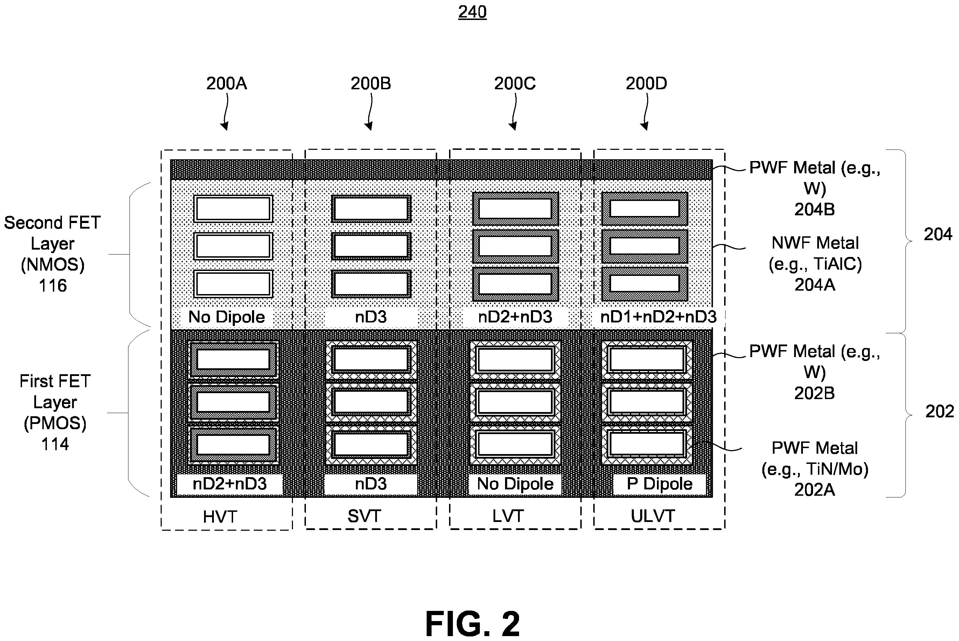

FIG. 2 depicts an example cross-sectional parallel-to-gate side view of a stacked CFET structure 240 along the cross-section line B in FIG. 1B, where like components have like reference numerals. Cross-section line B represents a parallel to gate (PGD) of four adjacent stacked CFET devices. DVB walls 138 between one or more of the stacked CFET devices is not depicted for clarity.

CFET structure 240 is shown comprising four stacked CFET devices 200. The four stacked CFET devices 200A - 200D (collectively CFET devices 200) are laterally adjacent in the x-direction between a bottom contact region and a top contact region (not shown) in the y-direction. Both the first FET layer 114 and the second FET layer 116 of each of the stacked CFET devices 200 comprise a patterned workfunction (PWF), which refers to the formation of gate electrodes with different work functions for the n-type and the p-type devices to optimize threshold voltages and performance of each transistor type.

The first FET layer 114 may comprise a PMOS or p-type layer, and the second FET layer 116 comprises an NMOS or n-type layer. The PMOS layer and the NMOS layer are in vertical alignment. In one embodiment, the PMOS layer includes a first plurality of channels in the form of ribbons surrounded by a first (PMOS) gate stack 202. The NMOS layer includes a second plurality of channels in the form of ribbons surrounded by a second (NMOS) gate stack 204.

In embodiments, the PMOS gate stack 202 and the NMOS gate 204 stack of the stacked CFET devices 200 include a high-k gate dielectric (not shown) on the ribbons. In one embodiment, the high-k gate dielectric may comprise thallium and oxygen, e.g., thallium oxide (Tl20)).

In one embodiment, the first gate stack 202 in the PMOS layer of each of the stacked CFET devices 200 comprises a first p-type work function (pWF) metal 202A over/on the high-k gate dielectric and a second pWF metal 202B over the first pWF 202A. In one embodiment, the first pWF metal 202A on the high-k dielectric may comprise for example titanium and nitrogen (e.g., titanium nitride (TiN) or molybdenum and nitrogen (e.g. molybdenum nitride (MoN)). The second pWF metal 202B may comprise tungsten (W).

In one embodiment, the second gate stack 204 in NMOS layer of each of the stacked CFET devices 200 comprises an nWF metal 204A and a pWF metal 204B. In one embodiment, the pWF metal 204B is the same as the second pWF metal 202B (e.g., tungsten (W)) used in the PMOS layer. The pWF metal 204B is over the high-k gate dielectric, and the nWF metal 204A is over the pWF metal 204B. The pWF metal 204B may comprise tungsten (W), and the nWF metal 204A may comprise titanium, aluminum, and carbide (TiAlC).

According to the disclosed embodiments, volumeless NMOS dipole (nD) and PMOS dipole (pD) are used for Vt separation, resulting in CFET structure 240 integrating multiple threshold voltages (Vt) into the stacked CFET devices 200, respectively.

In the context of CFET devices, the phrase "volumeless nD and pD for Vt separation" refers to a technique used to adjust the Vt of the n-type and p-type devices independently. The term "volumeless" refers to this technique not relying on changes in the doping concentrations or volumes of the semiconductor material itself. Instead, the work function of the metal gate stacks is altered to modulate the threshold voltages. Volumeless nD and pD result in metal gate stacks with different work functions for the n-type and the p-type devices, which allows for independent control of the threshold voltages.

According to the disclosed embodiments, the respective stacked CFET devices 200 include different threshold voltage (Vt) levels based on different combinations of N dipole doses and P dipole doses at an interface of the high-k dielectric and the pWF metal layer stack and at an interface of the high-k dielectric and the nWF metal layer stack.

PMOS dipole (pD) and NMOS dipole (nD) refer to depositing a thin capping metal layer at the interface of the metal gate and the high-k dielectric to independently adjust the Vt of the p-type and n-type devices, respectively. Plasma-enhanced vapor deposition (PVD) can be used to deposit atoms for dipole formation as the atoms of the capping metal layer (e.g., TiN or MoN) have to be driven into the high-k dielectric by high-temperature annealing. The dipole layer can alter the band alignment in the MOS stack, which can be used to modulate the threshold voltage (Vth).

In embodiments, the different N dipole doses or layers can be zero (none) up to three nD1, nD2, and nD3, but there could be additional N dipole doses in other embodiments. In one embodiment, the different P dipole doses or layers can be zero (none) or one pD1, but there could be additional P dipole doses in other embodiments. In one embodiment, the N dipole may comprise lanthanum (La) and the P dipole may comprise aluminum (Al).

In the stacked CFET device 200A, the PMOS layer includes the second dose and the third dose of the N dipole (nD2 + nD3) at the interface of the high-k dielectric and the pWF metal layer stack, and the NMOS layer does not include the N-dipole at the interface of the high-k dielectric and the nWF metal layer.

In the stacked CFET device 200B, the PMOS layer includes only the third dose of the N dipole (nD3) at the interface of the high-k dielectric and the pWF metal layer stack, and the NMOS layer includes only the third dose of the N dipole (nD3) at the interface of the high-k dielectric and the nWF metal layer.

In the stacked CFET device 200C, the PMOS layer does not include the N-dipole at the interface of the high-k dielectric and the pWF metal layer stack, and the NMOS layer includes the second and the third dose of the N dipole (nD2 + nD3) at the interface of the high-k dielectric and the nWF metal layer.

In the stacked CFET device 200D, the PMOS layer includes only the P dipole dose at the interface of the high-k dielectric and the pWF metal layer stack, and the NMOS layer includes the first dose, the second, and the third dose of the N-dipole (nD1 + nD2 + nD3) at the interface of the high-k dielectric and the nWF metal layer.

According to the disclosed embodiments, the different combinations of the N dipole doses, the P dipole dose, and different pWF and nWF metals in both the first metal gate stack and the second metal gate stack configure the respective ones of the plurality of stacked CFET devices with different threshold voltage (Vt) levels.

In one embodiment, CFET device 200A is configured with a high Vt (HVT), CFET device 200B is configured with a standard Vt (SVT), CFET device 200C is configured with a low Vt (LVT), and CFET device 200C is configured with an ultra-low Vt (ULVT). Different threshold voltage levels are employed to strike a balance between speed and power consumption.

The CFET structure 240 having stacked CFET devices 200 with different threshold voltage (Vt) levels of the disclosed embodiments offers a choice of the appropriate threshold voltage level depending on specific application requirements and the desired trade-off between performance and power consumption.

HVT devices have a relatively high threshold voltage ranging from 0.25V to 0.35 V. HVT devices exhibit low leakage current and low static power consumption when in the off state. However, HVT devices require a higher gate-to-source voltage (VGS) to turn on, resulting in slower switching speeds and lower drive currents when compared to lower Vt devices. HVT devices are typically used in low-power applications where minimizing leakage and static power consumption is a priority, even at the expense of reduced performance.

SVT devices may have a voltage threshold ranging from 0.2V to 0.3V, which is considered a moderate value. SVT devices strike a balance between performance and power consumption, offering reasonable switching speeds and drive currents while maintaining acceptable leakage levels. Standard SVT devices may be used in many general-purpose applications where both performance and power consumption are important considerations.

LVT devices have a lower threshold voltage ranging from 0.15V to 0.25V. LVT devices may exhibit higher drive currents and faster switching speeds compared to SVT and HVT devices to enable improved performance. However, any performance improvement comes at the cost of higher leakage currents and increased static power consumption. LVT devices may be used in high-performance applications where speed is the primary concern, and power consumption is a secondary consideration.

ULVT devices have an extremely low threshold voltage ranging from 0.1V to 0.2V. ULVT devices may have the highest drive currents and switching speeds among the different Vt levels to enable maximum performance. However, this performance advantage comes with significantly higher leakage currents and static power consumption, which can be a major concern in power-constrained applications. ULVT devices are typically used in high-performance computing, networking, and other applications where maximizing speed is the top priority, and power consumption is a secondary consideration or can be mitigated through other techniques.

The combination of different Vt levels is employed within the same CFET structure 240 of adjacent stacked CFET devices 200, where stacked device 200A and 200B configured for HVT and SVT levels may be selected for non-critical paths, stacked devices 200C and 200D having LVT or ULVT levels may be selected for critical paths that require maximum performance.

A high-k dielectric and metal gate (HKMG) stack has been described. The high-k gate dielectric is generally a thin film and can be silicon oxide, high-k materials, or any combination of these materials. Examples of high-k materials may further include but are not limited to metal oxides such as hafnium oxide, hafnium silicon oxide, hafnium silicon oxynitride, lanthanum oxide, lanthanum aluminum oxide, zirconium oxide, zirconium silicon oxide, zirconium silicon oxynitride, tantalum oxide, titanium oxide, barium strontium titanium oxide, barium titanium oxide, strontium titanium oxide, yttrium oxide, aluminum oxide, lead scandium tantalum oxide, and lead zinc niobate. The high-k materials may further include dopants such as lanthanum, aluminum, and magnesium. Gate dielectric can be deposited by CVD, ALD, or any other suitable technique. Metal gates can include any known metal gate material known to one skilled in the art, e.g., TiN, TiAl, TiC, TiAlC, tantalum (Ta) and tantalum nitride (TaN), W, Ru, Co, Al. Metal gates may be formed via known deposition techniques, such as atomic layer deposition, chemical vapor deposition, or physical vapor deposition. It should be appreciated that a chemical mechanical planarization (CMP) process can be applied to the top surface. In an embodiment, the work-function metal (WFM) layers may comprise titanium nitride, titanium aluminum nitride, titanium aluminum carbide, titanium aluminum carbon nitride, and tantalum nitride) and other appropriate metals and conducting metal layers (e.g., tungsten, cobalt, tantalum, aluminum, ruthenium, copper, metal carbides, and metal nitrides). The term work function metal includes a single metal layer as well as a stack of metal layers, or surface dipoles combined with a single or stack of metal layers.

Below a process is described for fabricating a CFET structure so that the stacked CFET devices will comprise a different WFM surrounding the upper and lower ribbon channels. Each WFM imparts a particular voltage threshold to the individual device such that each device has a different voltage threshold based at least on the particular WFM used in the lower PMOS layer and upper NMOS layer of the device.

The process assumes that at least four stacked CFET devices have been fabricated between a bottom contact region and a top contact region with no dipoles. Each of the stacked CFET devices comprises lower PMOS ribbon channels and upper NMOS ribbon channels over the lower PMOS ribbon channels. The stacked CFET devices are targeted for different Vts. For example, CFET device 200A is targeted to be configured with HVT and therefore includes a lower PHVT layer and an upper NHVT layer. CFET device 200B is targeted to be configured with SVT and therefore includes lower PSVT layer and upper NSVT layer. CFET device 200C is targeted to be configured with LVT and includes lower PLVT layer and upper NLVT layer. CFET device 200D is targeted to be configured with ULVT and includes lower PULVT layer and upper NULVT layer.

Generally, device WFM is applied by performing successive processes including blocking particular ones of the upper or lower ribbon channels of the CFET devices using an organic planarization layer (OPL) and patterning different combinations of N dipole doses and a P dipole does into selective ones of the upper or lower ribbon channels of one or more target CFET devices to form a target NMOS work function (nWF) and a target PMOS work function (pWF) and removing the OPL. The process continues iteratively until the completion of the patterning of the nWF and the pWF in the upper and lower ribbon channels. The process further includes the deposition of one or more gate metals.

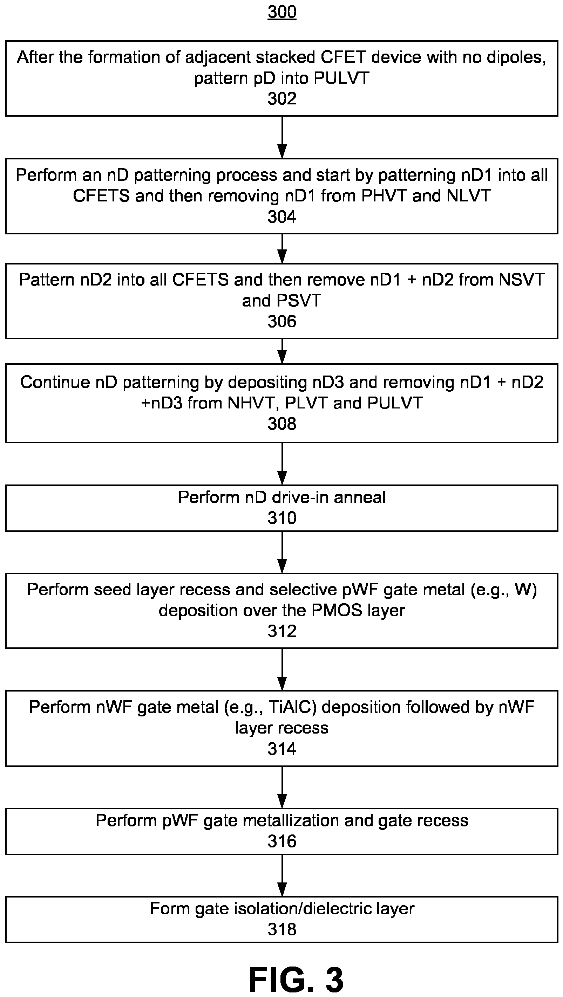

FIG. 3 is diagram illustrating a process 300 for fabricating a CFET structure comprising a plurality of adjacent stacked CFET devices using volumeless NMOS dipole (nD) and PMOS dipole (pD) for integrating multiple threshold voltages (Vt) into the stacked CFET devices. The stacked CFET devices are designated with a target Vt.

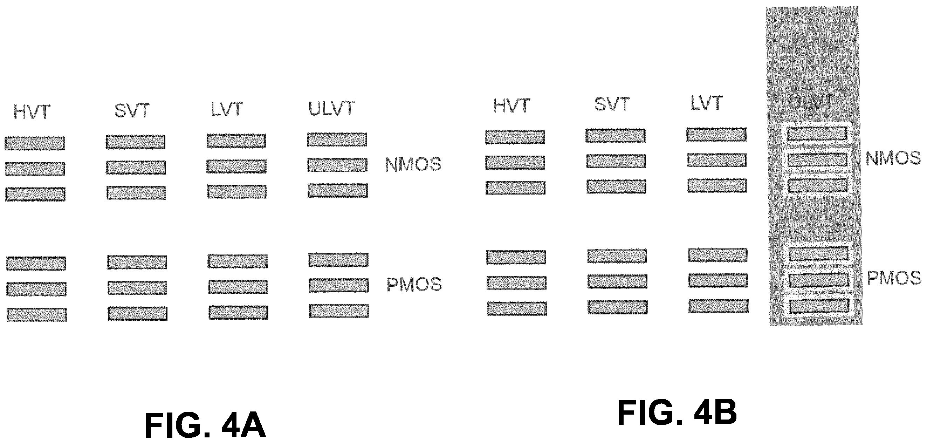

FIGS. 4A-4NN are diagrams illustrating cross-sectional views) views of sub-processes of the processes described in FIG. 3.

Referring to FIG. 3, given a plurality of stacked CFET devices with no dipoles, the process begins by patterning pD into PULVT (block 302).

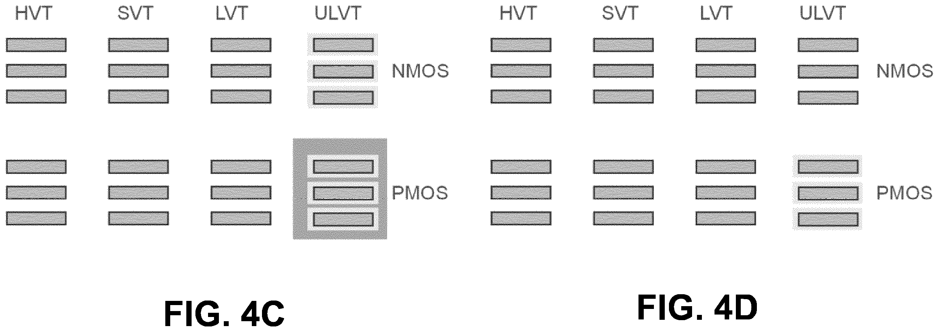

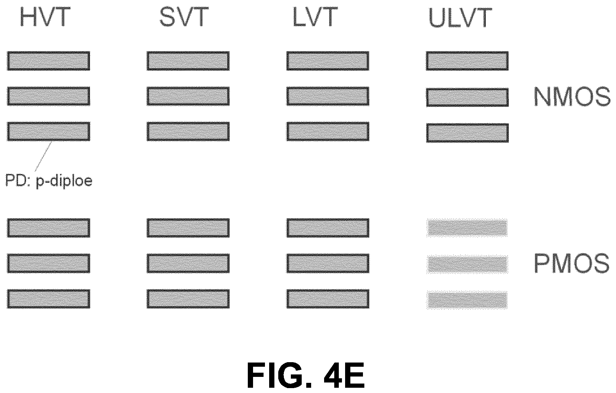

FIG. 4A shows that the process is done by patterning pD on all upper and lower layers. FIG. 4B shows the process after a protective layer, such as aluminum oxide (AL203), is applied to all CFETS (the protective layer is shown only on ULVT and ULVT) and after ULVT and ULVT are blocked with OPL (e.g., a carbon hardmask (CHM). FIG. 4C shows that pD is removed (e.g., by an ash process) from all unblocked upper and lower layers and that the PULVT is then blocked with OPL. CHM recess may be removed from the bottom ribbons and a sub-fin using a variety of standard processes. FIG. 4D shows that pD is removed from NULVT and that PULVT is unblocked. FIG. 4E shows a drive-in anneal is performed to drive the pD into the ribbons of the PULVT to create the P dipole.

Referring to FIG. 3, an nD patterning process starts by patterning nD1 into all CFETS and then removing nD1 from PHVT and NLVT (block 304).

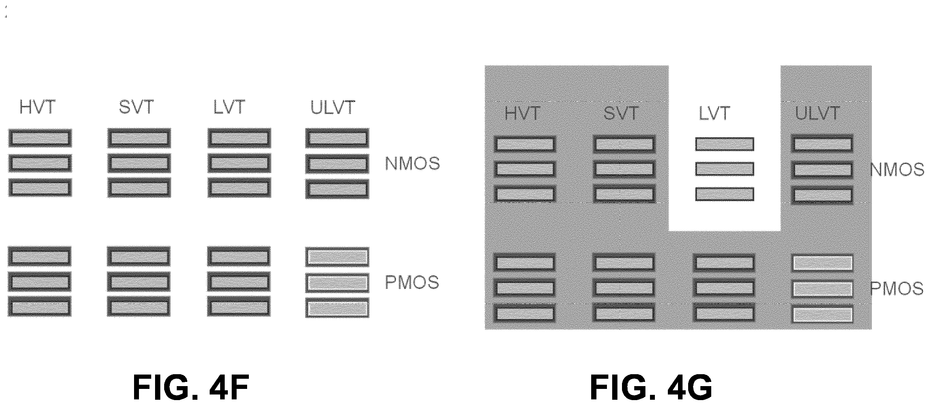

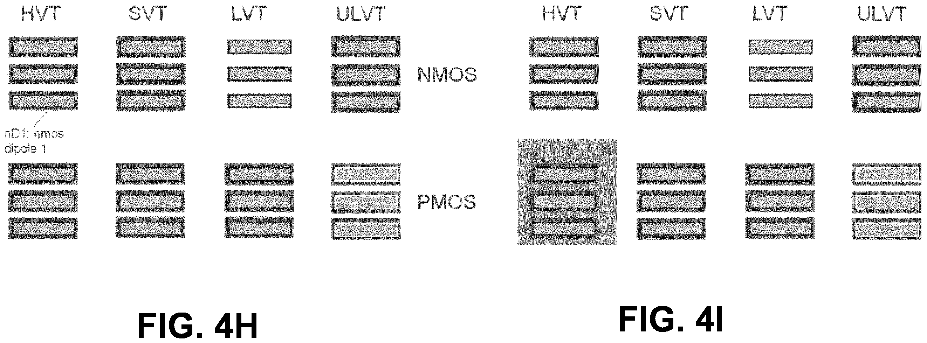

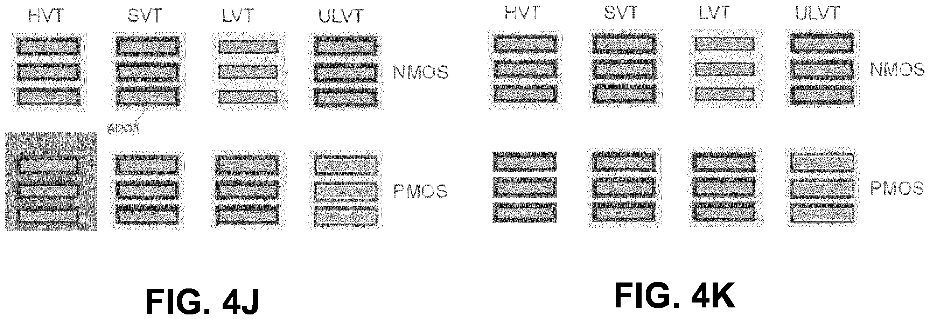

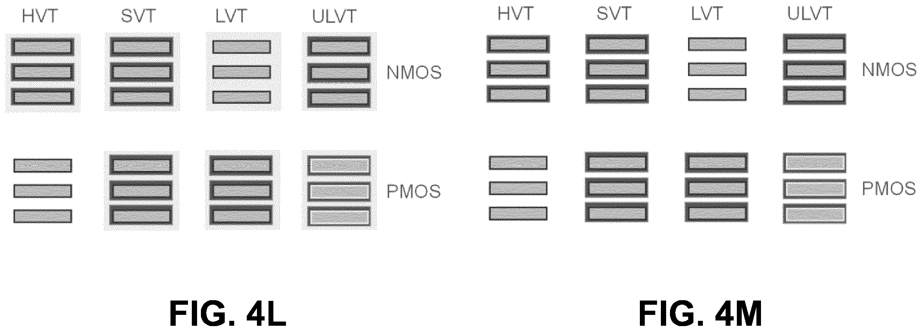

FIG. 4F shows the process once the nD1 dose is formed on all CFETS. FIG. 4G shows that all upper and lower layers are blocked with OPL except NLVT, and that nD1 is then removed only from NLVT. FIG. 4H shows the process after the OPL is removed and the start of the process to remove nD1 from PHVT. FIG. 4I shows that PHVT is first blocked with OPL. FIG. 4J shows that a protective layer, such as aluminum oxide (AL0x), is applied to all unblocked layers to protect the ribbons from the subsequent processing stages. FIG. 4K shows that the OPL over PHVT is removed. FIG. 4L shows that nD1 is removed from PHVT. FIG. 4M shows the removal of the protective layer.

Referring to FIG. 3, the process of the patterns nD2 into all CFETS and then removes nD1 + nD2 from NSVT and PSVT (block 306).

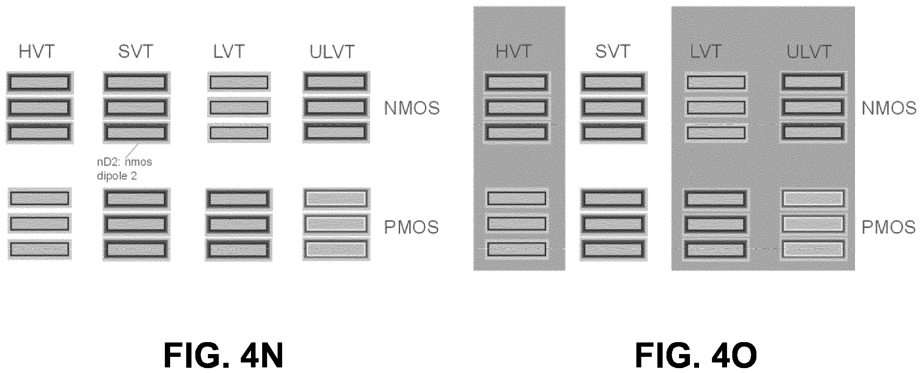

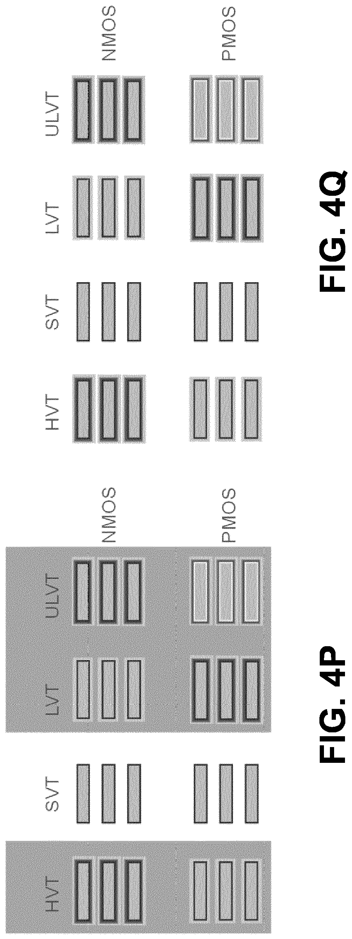

FIG. 4N shows the process of applying nD2 to all CFETs. FIG. 4O shows the process once the CFETS are blocked with OPL except NSVT and PSVT. FIG. 4P shows the removal of nD1 + nD2 from NSVT and PSVT. FIG. 4Q shows the process after the OPL is removed.

Referring to FIG. 3, the process proceeds with nD3 deposition and continues with a third 3rd nD patterning to remove nD1+nD2+nD3 from NHVT, PLVT, and PULVT (block 308).

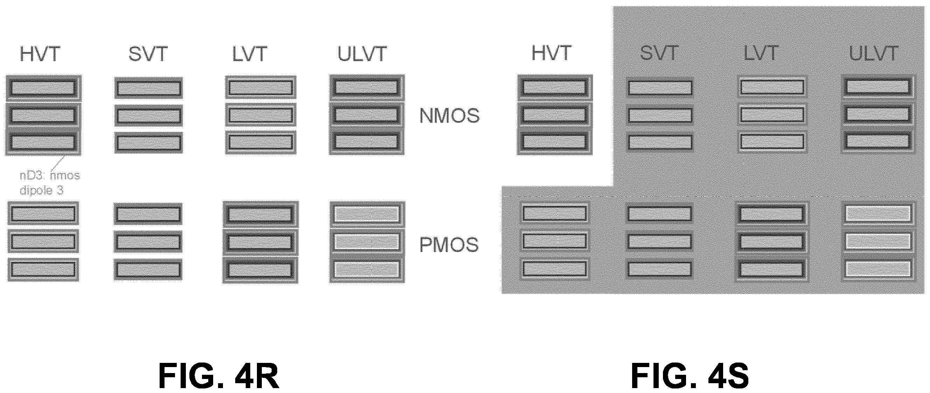

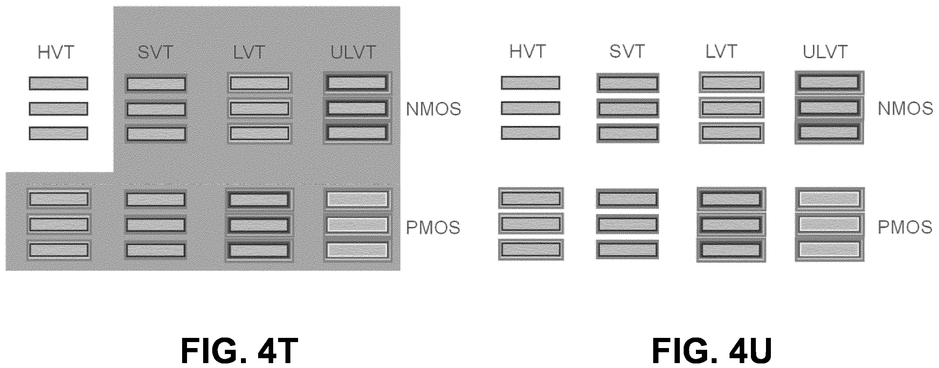

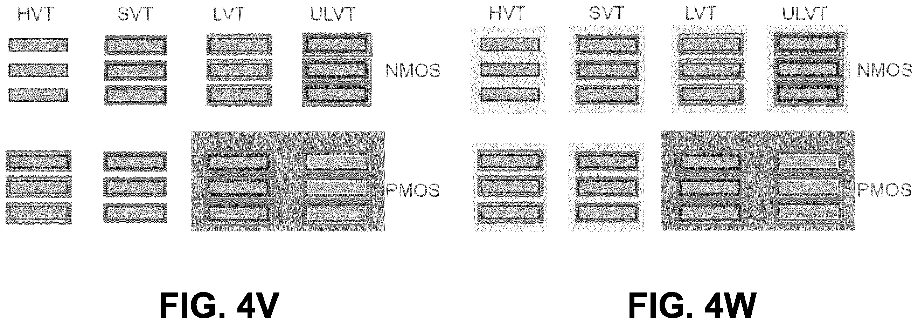

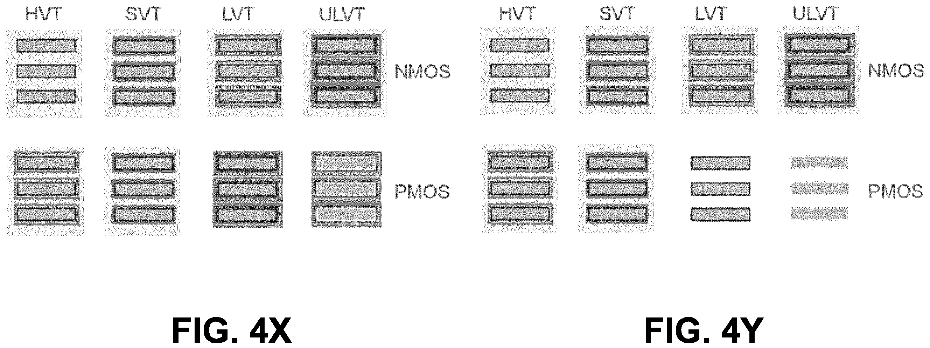

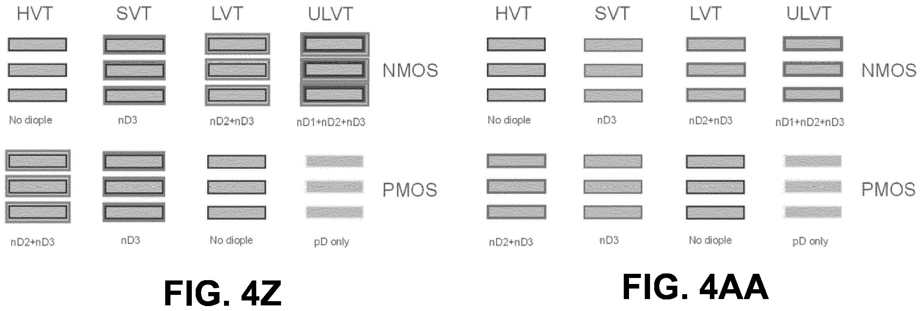

FIG. 4R shows the process after nD3 is applied to all CFETS and the beginning of the process to remove nD1 + nD2 + nD3 from NHVT. FIG. 4S shows the process after the OPL is applied to all CFETS except NHVT. FIG. 4T shows removal of nD1 + nD2 + nD3 from NHVT. FIG. 4U shows the removal of the OPL. FIG. 4V shows the beginning of the process to remove nD1 + nD2 + nD3 from PLVT and PULVT and that the process begins by applying OPL to all CFETS except PLVT and PULVT. FIG. 4W shows a protective layer (e.g., AL0x) applied to all unblocked layers to protect the ribbons from the subsequent processing stages. FIG. 4X shows that the OPL over PLVT and PULVT is removed. FIG. 4Y shows the removal of nD1 + nD2 + nD3 from PLVT and PULVT. FIG. 4Z shows the process after the removal of the protective layer.

Referring to FIG. 3, the process proceeds with nD drive-in anneal (block 310).

FIG. 4AA shows the process after nD is driven into all CFETS except NHVT, PLVT, and PULVT and the completion of the nD patterning.

Referring to FIG. 3, the process proceeds with performing pWF seed layer recess and selective pWF gate metal (e.g., W) deposition over the PMOS layer (block 312).

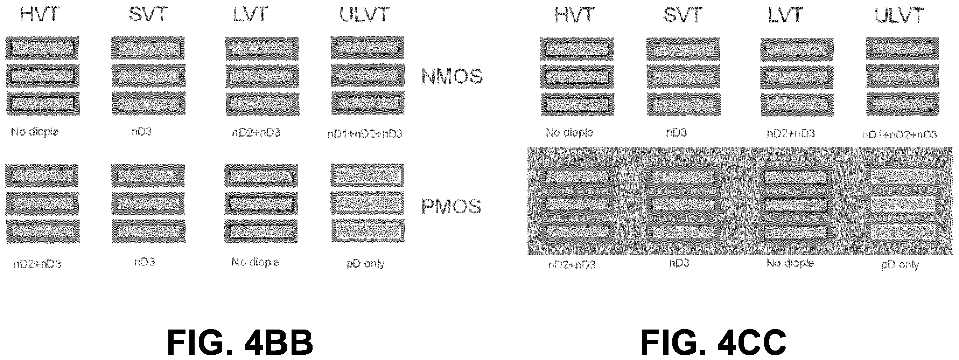

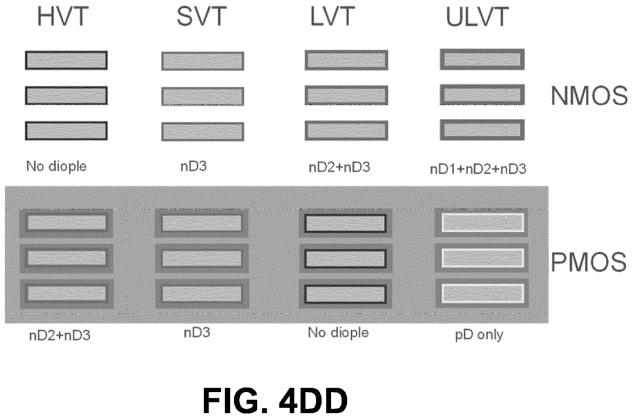

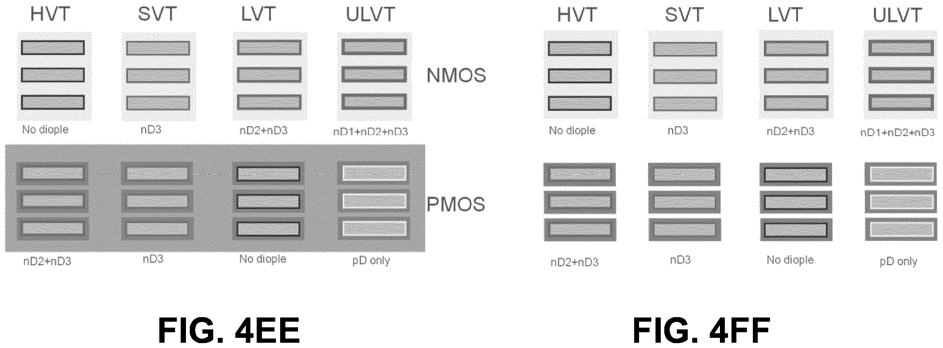

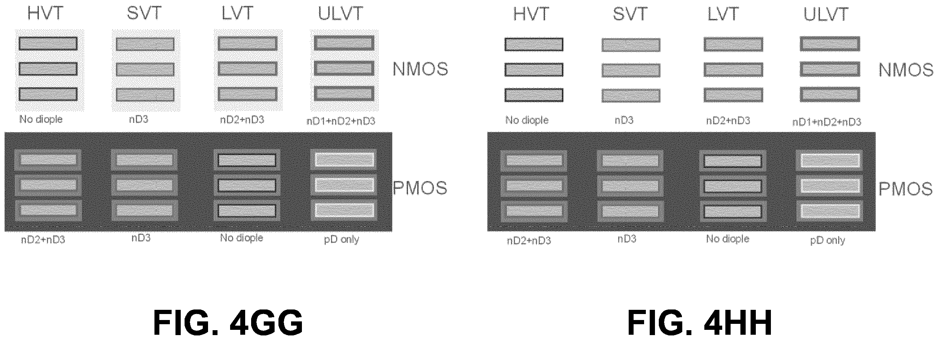

FIG. 4BB shows the process after pD is applied to all CFETS. FIG. 4CC shows the process after the PMOS layer is blocked with OPL. FIG. 4DD shows the process after the pD is removed from the NMOS layer. FIG. 4EE shows a protective layer applied to the unblocked NMOS layers. FIG. 4FF shows the removal of the OPL. FIG. 4GG shows the process after pWF gate meal deposition over the PMOS layer. FIG. 4HH shows the removal of the protective layer from the NMOS layer.

Referring to FIG. 3, the process proceeds with nWF gate metal (e.g., TiAlC) deposition in a recess on top of the NMOS layer followed by nWF layer recess (block 314).

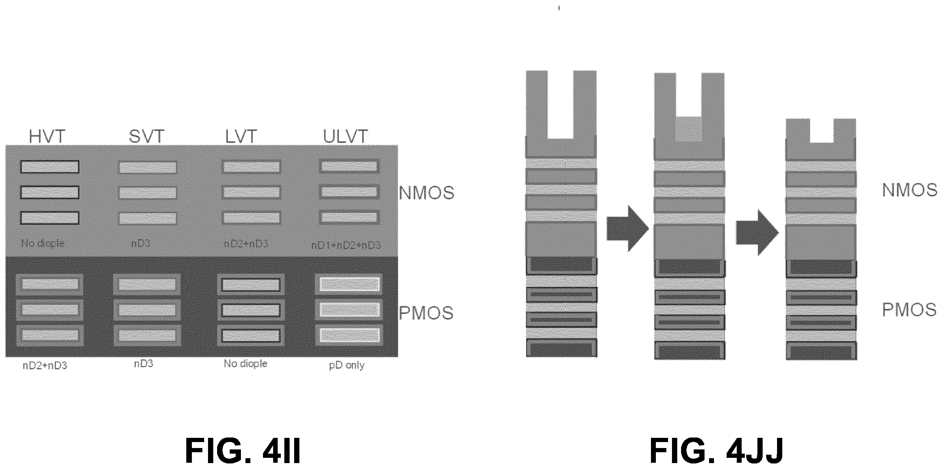

FIGS. 4II and 4JJ show a parallel-to-gate (PGD) view and an orthogonal-to-gate (OGD) view, respectively, of the deposition of the nWF gate metal (e.g., TiAlC) in a recess on top of the NMOS layer and subsequent metal gate recess (not viewable in FIG. 4II).

Referring to FIG. 3, the process proceeds pWF gate metallization and gate recess (block 316).

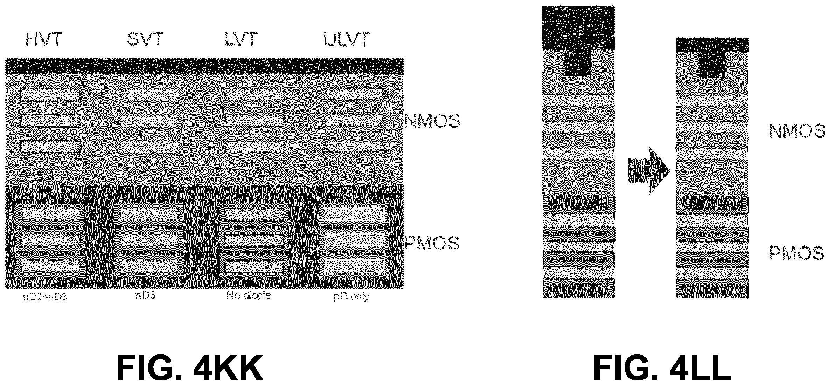

FIGS. 4KK and 4LL show a PGD view and an OGDEN view, respectively, of the deposition of the pWF gate metal on top of the nWF gate metal and gate recess and subsequent metal gate recess (not viewable in FIG. 4KK).

Referring to FIG. 3, the process proceeds with the forming a gate isolation/dielectric layer (block 318).

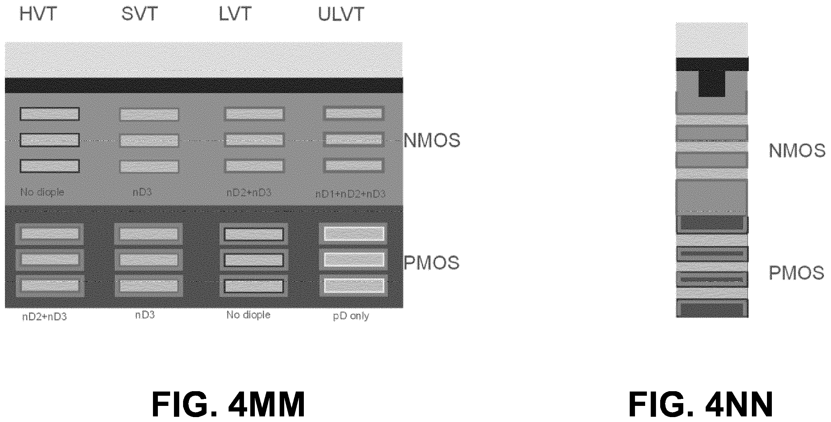

FIGS. 4MM and 4NN show a PGD view and an OGD view, respectively, of the formation of the dielectric material.

According to the disclosed embodiments, the CFET structure comprises at least four adjacent ribbons CFETS comprising different doses of N dipole (La) and a P dipole (AL) at the interface of a high-k gate dialectic. As described in FIG. 2, the PMOS metal gate stack comprises a first pWF metal 202A (e.g., W) over a second pWF metal 202B (e.g., TiN or MoN). In one embodiment, the NMOS gate stack comprises a pWF gate metal 204B (e.g., W) and an nWF gate metal 204A (e.g., TiAlC) over the pWF gate metal 204B.

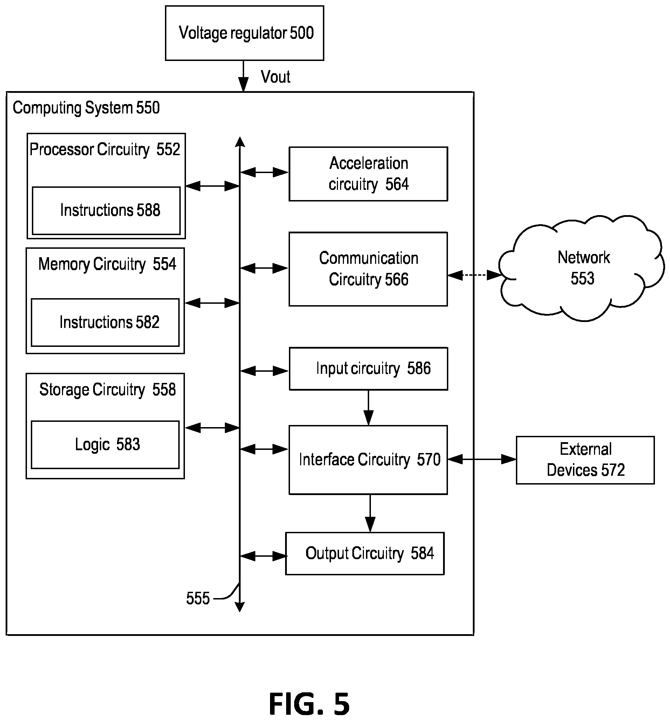

FIG. 5 illustrates an example of components that may be present in a computing system 550 for implementing the techniques (e.g., operations, processes, methods, and methodologies) described herein. The CFET memory cell described herein can be used in any of the components of the computing system 550. One example implementation involves the memory circuitry 554.

The voltage regulator 500 may provide a voltage Vout to one or more of the components of the computing system 550.

The memory circuitry 554 may store instructions and the processor circuitry 552 may execute the instructions to perform the functions described herein.

The computing system 550 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 550, or as components otherwise incorporated within a chassis of a larger system. For one embodiment, at least one processor 552 may be packaged together with computational logic 582 and configured to practice aspects of various example embodiments described herein to form a System in Package (SiP) or a System on Chip (SoC).

The system 550 includes processor circuitry in the form of one or more processors 552. The processor circuitry 552 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 552 may include one or more hardware accelerators (e.g., same or similar to acceleration circuitry 564), which may be microprocessors, programmable processing devices (e.g., FPGA, ASIC, etc.), or the like. The one or more accelerators may include, for example, computer vision and/or deep learning accelerators. In some implementations, the processor circuitry 552 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 552 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 552 may be coupled with or may include memory/storage and may be configured to execute instructions stored in the memory/storage to enable various applications or operating systems to run on the platform 550. The processors (or cores) 552 is configured to operate application software to provide a specific service to a user of the platform 550. In some embodiments, the processor(s) 552 may be a special-purpose processor(s)/controller(s) configured (or configurable) to operate according to the various embodiments herein.

As examples, the processor(s) 552 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 552 may be a part of a system on a chip (SoC), System-in-Package (SiP), a multi-chip package (MCP), and/or the like, in which the processor(s) 552 and other components are formed into a single integrated circuit, or a single package. Other examples of the processor(s) 552 are mentioned elsewhere in the present disclosure.

The system 550 may include or be coupled to acceleration circuitry 564, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 564 may comprise logic blocks or logic fabric and other interconnected resources that may be programmed (configured) to perform various functions, such as the procedures, methods, functions, etc. of the various embodiments discussed herein. In such implementations, the acceleration circuitry 564 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 552 and/or acceleration circuitry 564 may include hardware elements specifically tailored for machine learning and/or artificial intelligence (AI) functionality. In these implementations, the processor circuitry 552 and/or acceleration circuitry 564 may be, or may include, an AI engine chip that can run many different kinds of AI instruction sets once loaded with the appropriate weightings and training code. Additionally or alternatively, the processor circuitry 552 and/or acceleration circuitry 564 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google^{®} Inc., Real AI Processors (RAPs^{™}) provided by AlphaICs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 552 and/or acceleration circuitry 564 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 or A12 Bionic SoC, the Neural Processing Unit (NPU) within the HiSilicon Kirin 970 provided by Huawei^{®}, and/or the like. In some hardware-based implementations, individual subsystems of system 550 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 550 also includes system memory 554. Any number of memory devices may be used to provide for a given amount of system memory. As examples, the memory 554 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 554 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 554 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 558 provides persistent storage of information such as data, applications, operating systems and so forth. In an example, the storage 558 may be implemented via a solid-state disk drive (SSDD) and/or high-speed electrically erasable memory (commonly referred to as "flash memory"). Other devices that may be used for the storage 558 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 554 and/or storage circuitry 558 may also incorporate three-dimensional (3D) cross-point (XPOINT) memories from Intel^{®} and Micron^{®}.

The memory circuitry 554 and/or storage circuitry 558 is/are configured to store computational logic 583 in the form of software, firmware, microcode, or hardware-level instructions to implement the techniques described herein. The computational logic 583 may be employed to store working copies and/or permanent copies of programming instructions, or data to create the programming instructions, for the operation of various components of system 550 (e.g., drivers, libraries, application programming interfaces (APIs), etc.), an operating system of system 550, one or more applications, and/or for carrying out the embodiments discussed herein. The computational logic 583 may be stored or loaded into memory circuitry 554 as instructions 582, or data to create the instructions 582, which are then accessed for execution by the processor circuitry 552 to carry out the functions described herein. The processor circuitry 552 and/or the acceleration circuitry 564 accesses the memory circuitry 554 and/or the storage circuitry 558 over the interconnect (IX) 566. The instructions 582 direct the processor circuitry 552 to perform a specific sequence or flow of actions, for example, as described with respect to flowchart(s) and block diagram(s) of operations and functionality depicted previously. The various elements may be implemented by assembler instructions supported by processor circuitry 552 or high-level languages that may be compiled into instructions 588, or data to create the instructions 588, to be executed by the processor circuitry 552. The permanent copy of the programming instructions may be placed into persistent storage devices of storage circuitry 558 in the factory or in the field through, for example, a distribution medium (not shown), through a communication interface (e.g., from a distribution server (not shown)), over-the-air (OTA), or any combination thereof.

The IX 566 couples the processor 552 to communication circuitry 566 for communications with other devices, such as a remote server (not shown) and the like. The communication circuitry 566 is a hardware element, or collection of hardware elements, used to communicate over one or more networks 553 and/or with other devices. In one example, communication circuitry 566 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 566 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 566 also couples the processor 552 to interface circuitry 570 that is used to connect system 550 with one or more external devices 572. The external devices 572 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 550, which are referred to as input circuitry 586 and output circuitry 584. The input circuitry 586 and output circuitry 584 include one or more user interfaces designed to enable user interaction with the platform 550 and/or peripheral component interfaces designed to enable peripheral component interaction with the platform 550. Input circuitry 586 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 584 may be included to show information or otherwise convey information, such as sensor readings, actuator position(s), or other like information. Data and/or graphics may be displayed on one or more user interface components of the output circuitry 584. Output circuitry 584 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 550. The output circuitry 584 may also include speakers and/or other audio emitting devices, printer(s), and/or the like. Additionally or alternatively, sensor(s) may be used as the input circuitry 586 (e.g., an image capture device, motion capture device, or the like) and one or more actuators may be used as the output device circuitry 584 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 550 may communicate over the IX 566. The IX 566 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 566 may be a proprietary bus, for example, used in a SoC based system.

The number, capability, and/or capacity of the elements of system 550 may vary, depending on whether computing system 550 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 550 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

In various implementations, the computing device 500 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 500 may be any other electronic device that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Embodiment 1. A complementary field-effect transistor (CFET) structure, comprising: a bottom contact region; a top contact region; and a plurality of stacked CFET devices between the bottom contact region and the top contact region, respective ones of the plurality of stacked CFET devices comprising; a first transistor layer of a first type over the bottom contact region, the first transistor layer comprising a first plurality of channels surrounded by a first metal gate stack; and a second transistor layer of a second type over the first transistor layer, the second transistor layer comprising a second plurality of channels surrounded by a second metal gate stack; wherein the respective ones of the plurality of stacked CFET devices include different combinations of N dipole doses and a P dipole dose in both the first metal gate stack and the second metal gate stack.

Embodiment 2. The CFET structure of Embodiment 1, wherein the different combinations of the N dipole doses and the P dipole dose in both the first metal gate stack and the second metal gate stack configure the respective ones of the plurality of stacked CFET devices with different threshold voltage (Vt) levels, the respective ones of the plurality of stacked CFET devices includes a first stacked CFET device configured with a first Vt ranging from 0.25V to 0.35 V.

Embodiment 3. The CFET structure of Embodiment 2, wherein the respective ones of the plurality of stacked CFET devices include a second CFET device configured with a second Vt ranging from 0.2V to 0.3V.

Embodiment 4. The CFET structure of Embodiment 2, wherein the respective ones of the plurality of stacked CFET devices include a third CFET device configured with a third Vt ranging from 0.15V to 0.25V.

Embodiment 5. The CFET structure of claim 2, wherein the respective ones of the plurality of stacked CFET devices include a fourth CFET device configured with a fourth Vt ranging from 0. 1V to 0.2V.

Embodiment 6. The CFET structure of claim 1, 2, 3, 4, or 5, wherein the first transistor layer comprises a PMOS layer and the second transistor layer comprises an NMOS layer.

Embodiment 7. The CFET structure of claim 1, 2, 3, 4, 5, or 6, wherein the first metal gate stack in the PMOS layer comprises a first p-type work function metal (pWF metal) over a high-k gate dielectric, and a second pWF metal over the first pWF metal; and the second metal gate in the NMOS layer comprises the second pWF metal over the high-k gate dielectric, and an nWF metal over the second pWF metal.

Embodiment 8. The CFET structure of claim 7, wherein the first pWF metal comprises titanium and nitrogen or molybdenum and nitrogen, and the second pWF metal comprises tungsten.

Embodiment 9. The CFET structure of claim 7, wherein the nWF metal comprises titanium, aluminum, and carbide.

Embodiment 10. The CFET structure of claim 7, wherein the high-k gate dielectric comprises thallium and oxygen.

Embodiment 11. The CFET structure of claim 1, 2, 3, 4, 5, 6, 7, 8, 9, or 10, wherein the N dipole comprises lanthanum (La).

Embodiment 12. The CFET structure of claim 1, 2, 3, 4, 5, 6, 7, 8, 9, 10, or 11, wherein the P dipole comprises aluminum (Al).

Embodiment 13. A complementary field-effect transistor (CFET) structure, comprising: a plurality of stacked CFET devices adjacent to one another, respective ones of the plurality of stacked CFET devices comprising: a PMOS layer comprising a first plurality of ribbons surrounded by a high-k dielectric and a pWF metal layer stack; and an NMOS layer comprising a second plurality of ribbons surrounded by the high-k dielectric and an nWF metal layer stack; wherein the respective ones of the plurality of stacked CFET devices include different threshold voltage (Vt) levels based on different combinations of N dipole doses and a P dipole dose at an interface of the high-k dielectric and the pWF metal layer stack and an interface of the high-k dielectric and the nWF metal layer stack, the N dipole doses comprising a first dose (nD1), a second dose (nD2), and a third dose (nD3).

Embodiment 14. The stacked CFET device of Embodiment 13, wherein the respective ones of the plurality of stacked CFET devices include: a first stacked CFET device in which the PMOS layer includes the second dose and the third dose of the N dipole (nD2 + nD3) at the interface of the high-k dielectric and the pWF metal layer stack, and the NMOS layer does not include any of the N-dipole doses at the interface of the high-k dielectric and the nWF metal layer.

Embodiment 15. The stacked CFET device of Embodiment 13 or 14, wherein the respective ones of the plurality of stacked CFET devices include: a second CFET device in which the PMOS layer includes the third dose of the N dipole (nD3) at the interface of the high-k dielectric and the pWF metal layer stack, and the NMOS layer includes the third dose of the N dipole (nD3) at the interface of the high-k dielectric and the nWF metal layer.

Embodiment 16. The stacked CFET device of Embodiment 13, 14, or 15, wherein the respective ones of the plurality of stacked CFET devices include: a third CFET device in which the PMOS layer does not include the N-dipole at the interface of the high-k dielectric and the pWF metal layer stack, and the NMOS layer includes the second and the third dose of the N dipole (nD2 + nD3) at the interface of the high-k dielectric and the nWF metal layer.

Embodiment 17. The stacked CFET device of Embodiment 13, 14, 15, or 16, wherein the respective ones of the plurality of stacked CFET devices include: a fourth CFET device in which the PMOS layer includes only the P dipole dose at the interface of the high-k dielectric and the pWF metal layer stack, and the NMOS layer includes the first dose, the second, and the third dose (nD1 + nD2 + nD3) of the N dipole at the interface of the high-k dielectric and the nWF metal layer.

Embodiment 18. A method for fabricating a complementary field-effect device (CFET) structure comprising: fabricating a plurality of stacked CFET devices with upper and lower ribbon channels with no dipoles; performing successive processes including blocking particular ones of the upper and lower ribbon channels of the CFET devices using an organic planarization layer (OPL) and patterning different combinations of N dipole doses and a P dipole does into selective ones of the upper or lower ribbon channels of one or more target CFET devices to form a target NMOS work function (nWF) and a target PMOS work function (pWF) and removing the OPL; continuing the process iteratively until completion of the patterning of the nWF and the pWF in the upper and lower ribbon channels; and depositing of one or more gate metals.

Embodiment 19. The method of Embodiment 18 wherein fabricating stacked CFET devices further comprises: targeting a first one of the stacked CFET devices to be configured with a first threshold voltage; targeting a second one of the stacked CFET devices to be configured with a second threshold voltage; targeting a third one of the stacked CFET devices to be configured with a third threshold voltage; and targeting a fourth one of the stacked CFET devices to be configured with a fourth threshold voltage layer.

Embodiment 20. The method of Embodiment 18 or 19 further comprising: fabricating a first metal gate stack in a PMOS layer of the CFET devices, the first metal gate stack comprising a first pWF metal over a high-k gate dielectric, and a second pWF metal over the first pWF metal; and fabricating a second metal gate in a NMOS layer of the CFET devices, the second metal gate stack comprising the second pWF metal over the high-k gate dielectric, and an nWF metal over the second pWF metal.

Embodiment 21. A complementary field-effect transistor (CFET) array including a plurality of rows, and columns, the CFET array comprising: a bottom contact region; a top contact region, the top contact region comprising a first contact line and a second contact line; a plurality of CFET cells, ones of the plurality of CFET cells located along particular ones of the plurality of columns and comprise a plurality of CFET transistors, the plurality of CFET transistors comprising: a PMOS layer comprising a first plurality of ribbons surrounded by a high-k dielectric and a pWF metal layer stack; a NMOS layer comprising a second plurality of ribbons surrounded by the high-k dielectric and an nWF metal layer stack; wherein the respective ones of the plurality of CFET transistors include different threshold voltage (Vt) levels based on different combinations of N dipole doses and P dipole doses at an interface of the high-k dielectric and the pWF metal layer stack and at an interface of the high-k dielectric and the nWF metal layer stack, the N dipole doses comprising a first dose (nD1), a second dose (nD2), and a third dose (nD3).

Embodiment 22. The CFET array of Embodiment 21, wherein the pWF metal gate stack in the PMOS layer comprises a first pWF metal over a high-k gate dielectric, and a second pWF metal over the first pWF metal; and the nWF metal gate stack in the NMOS layer comprises the second pWF metal over the high-k gate dielectric, and an nWF metal over the second pWF metal.

Embodiment 23. The CFET array of Embodiment 21 or 22, wherein the N dipole comprises lanthanum (La) and the P dipole comprises aluminum (Al).

Embodiment 24. The CFET array of Embodiment 21, 22, or 23, wherein the high-k gate dielectric comprises thallium and oxygen.

## Claims

1. A complementary field-effect transistor (CFET) structure, comprising:
a bottom contact region;
a top contact region; and
a plurality of stacked CFET devices between the bottom contact region and the top contact region, respective ones of the plurality of stacked CFET devices comprising;
a first transistor layer of a first type over the bottom contact region, the first transistor layer comprising a first plurality of channels surrounded by a first metal gate stack; and
a second transistor layer of a second type over the first transistor layer, the second transistor layer comprising a second plurality of channels surrounded by a second metal gate stack; and
wherein the respective ones of the plurality of stacked CFET devices include different combinations of N dipole doses and a P dipole dose in both the first metal gate stack and the second metal gate stack.

2. The CFET structure of claim 1, wherein the different combinations of the N dipole doses and the P dipole dose in both the first metal gate stack and the second metal gate stack configure the respective ones of the plurality of stacked CFET devices with different threshold voltage (Vt) levels, the respective ones of the plurality of stacked CFET devices include a first stacked CFET device configured with a first Vt ranging from 0.25V to 0.35V.

3. The CFET structure of claim 2, wherein the respective ones of the plurality of stacked CFET devices include a second CFET device configured with a second Vt ranging from 0.2V to 0.3V.

4. The CFET structure of claim 2, wherein the respective ones of the plurality of stacked CFET devices include a third CFET device configured with a third Vt ranging from 0.15V to 0.25V.

5. The CFET structure of claim 2, wherein the respective ones of the plurality of stacked CFET devices include a fourth CFET device configured with a fourth Vt ranging from 0.1V to 0.2V.

6. The CFET structure of claim 1, 2, 3, 4 or 5, wherein the first transistor layer comprises a PMOS layer and the second transistor layer comprises an NMOS layer.

7. The CFET structure of claim 1, 2, 3, 4, 5 or 6, wherein:
the first metal gate stack in the PMOS layer comprises a first p-type work function metal (pWF metal) over a high-k gate dielectric, and a second pWF metal over the first pWF metal; and
the second metal gate in the NMOS layer comprises the second pWF metal over the high-k gate dielectric, and an nWF metal over the second pWF metal.

8. The CFET structure of claim 7, wherein the first pWF metal comprises titanium and nitrogen or molybdenum and nitrogen, and the second pWF metal comprises tungsten.

9. The CFET structure of claim 7, wherein the nWF metal comprises titanium, aluminum, and carbide.

10. The CFET structure of claim 7, wherein the high-k gate dielectric comprises thallium and oxygen.

11. The CFET structure of claim 1, 2, 3, 4, 5, 6, 7, 8, 9 or 10, wherein the N dipole comprises lanthanum (La).

12. The CFET structure of claim 1, 2, 3, 4, 5, 6, 7, 8, 9, 10 or 11, wherein the P dipole comprises aluminum (Al).

13. A method for fabricating a complementary field-effect device (CFET) structure comprising:
fabricating a plurality of stacked CFET devices with upper and lower ribbon channels with no dipoles;
performing successive processes including blocking particular ones of the upper and lower ribbon channels of the CFET devices using an organic planarization layer (OPL) and patterning different combinations of N dipole doses and a P dipole does into selective ones of the upper or lower ribbon channels of one or more target CFET devices to form a target NMOS work function (nWF) and a target PMOS work function (pWF) and removing the OPL;
continuing the process iteratively until completion of the patterning of the nWF and the pWF in the upper and lower ribbon channels; and
depositing of one or more gate metals.

14. The method of claim 13 wherein fabricating stacked CFET devices further comprises:
targeting a first one of the stacked CFET devices to be configured with a first threshold voltage;
targeting a second one of the stacked CFET devices to be configured with a second threshold voltage;
targeting a third one of the stacked CFET devices to be configured with a third threshold voltage; and
targeting a fourth one of the stacked CFET devices to be configured with a fourth threshold voltage layer.

15. The method of claim 13 or 14 further comprising:
fabricating a first metal gate stack in a PMOS layer of the CFET devices, the first metal gate stack comprising a first pWF metal over a high-k gate dielectric, and a second pWF metal over the first pWF metal; and
fabricating a second metal gate in a NMOS layer of the CFET devices, the second metal gate stack comprising the second pWF metal over the high-k gate dielectric, and an nWF metal over the second pWF metal.
